# EUROPÄISCHE PATENTSCHRIFT

(11) **EP 0 491 072 B1**
(45) Veröffentlichungstag und Bekanntmachung des Hinweises auf die Patenterteilung: **24.05.1995**
(21) Anmeldenummer: 90124629.8
(22) Anmeldetag: 18.12.1990
(51) Int. Cl.: H04R 25/02, H01R 13/24, H01R 23/72

(54) **Hörgerät**
Hearing aid
Prothèse auditive

(43) Veröffentlichungstag der Anmeldung: 24.06.1992
(73) Patentinhaber: SIEMENS AKTIENGESELLSCHAFT, 80333 München (DE)
(72) Erfinder: Moser, Benno, CH-6314 Unterägeri (CH); Schiess, Hans-Rudolf, CH-5620 Zufikon (CH)

(56) Entgegenhaltungen:
- DE-A- 2 652 683
- DE-A- 3 224 668
- DE-A- 3 623 906
- DE-U- 8 630 860
- US-A- 4 194 800
- US-A- 4 221 444

## Beschreibung

Die Erfindung betrifft ein Hörgerät nach dem Oberbegriff des Patentanspruches 1.

Die DE-A-36 23 906 beschreibt ein Hörgerät dieser Art, jedoch mit einer federnd ausgebildeten Leiterplatte, wobei im Inneren des Hörgerätes vorgesehene Bauelemente federnd und lösbar zwischen der federnden Leiterplatte und einem zugeordneten Gegenstück des Gehäuses eingeklemmt sind, derart, daß sich eine Kontaktierung zwischen den Leiterbahnen der Leiterplatte über den unter stetem Kontaktdruck stehenden anisotropen Körper zu den Kontakten der Bauelemente ergibt. Eine Lösung für die Anordnung und Ausbildung elektrischer Bauelemente, wie Steller, Potentiometer oder Schalter, ist in diesem Dokument nicht offenbart.

Aus der US-A-4 221 444 ist eine besonders dicht gekapselte leitende Verbindung zwischen zwei Leiterplatten mittels einer Elastomereinlage bekannt, die aus aneinander liegenden Lagen aus elektrisch leitenden bzw. isolierenden Zonen besteht. Die Leiterplatten und die Elastomereinlage werden fest in ein Gehäuse eingebaut, wobei die Leiterplatten unter Zwischenlage der Elastomereinlage gegeneinander verschraubbar sind.

Bei anderen bekannten Hörgeräten werden die elektrischen Kontakte der Hörgerätebauteile durch elektrische Leitungsdrähte mit den Federkontakten der Stromquelle und Anschlüssen einer Leiterplatte, die einen elektrischen Schaltkreis bildet, verbunden. Bedienelemente, wie Steller, Potentiometer, Schalter, können dabei entweder direkt auf die Leiterplatte oder mittels Litzen oder flexiblen Leitern an die Leiterplatte bzw. deren Leiterbahnen gelötet werden. Um einen raumsparenden Aufbau der Verstärkereinrichtung zu erreichen, ist es aus der DE-A-32 45 030 bekannt, für direkt an der Verstärkerplatine (Leiterplatte) anzubringende Bauteile in der Trägerplatte der Platine bzw. Leiterplatte Öffnungen vorzusehen, in die die Bauteile einsetzbar sind, wobei die Bauteile mit ihren elektrischen Anschlußdrähten oder Lötbeinchen mit den Leiterbahnen der Trägerplatte verlötet werden, während die Bauteile selbst in die Öffnungen der Trägerplatte einklemmbar sein sollen.

Die bekannten Lösungen sind bezüglich der Kontaktierung der Bauteile aufwendig, wobei insbesondere die Herstellung der Lötverbindungen als nachteilig angesehen wird.

Aufgabe der Erfindung ist es, ein Hörgerät der eingangs genannten Art mit montagefreundlichen Verbindungen zwischen den Schaltern, Potentiometern oder Stellern und der Leiterplatte zu schaffen, wobei Lötverbindungen vermeidbar und die Bauelemente leicht auswechselbar befestigbar sind.

Erfindungsgemäß wird diese Aufgabe bei einem Hörgerät nach Anspruch 1 gelöst.

Bei einem erfindungsgemäßen Hörgerät ist eine lötfreie Montage der Bedienelemente: Steller, Potentiometer und/oder Schalter möglich. Die elektrische Verbindung der Bedienelemente zur Leiterplatte erfolgt mittels eines anisotropen, elektrisch leitenden Körpers, der zwischen den elektrischen Anschlüssen der Bedien-oder Bauelemente und den Abgriffen der Leiterbahnen oder direkt den Leiterbahnen einer Leiterplatte bzw. eines Trägers der Leiterbahnen im Hörgerät angeordnet ist. Ein anisotroper elektrisch leitender platten-oder folienförmiger Körper sowie ein Verfahren zu seiner Herstellung sind aus der DE-B-26 52 683 an sich bekannt. Wird ein Kontaktdruck zwischen den Bauelementen, dem anisotropen Körper und den Leiterbahnen oder Leiterbahnanschlüssen hergestellt, beispielsweise durch eine Haltevorrichtung oder eine Schraubverbindung, so ergibt sich eine leitende Verbindung von den Leiterbahnen über die ausgerichteten elektrisch leitenden Fasern des anisotropen Körpers zu den elektrischen Anschlüssen der Bau- oder Bedienelemente. Während die in Richtung des Kontaktdruckes in das Matrixmaterial eingebetteten Fasern eine elektrisch leitende Verbindung ermöglichen und sich druckempfindliche elektrische Kontaktpunkte in der zur Ebene des zum Beispiel plattenförmigen Körpers senkrechten Richtung bilden, ergeben sich in den in der Ebene des plattenförmigen Körpers liegenden Richtungen keine leitenden Verbindungen; in diesen Ebenen bildet das Matrixmaterial einen genügend hohen isolierenden Widerstand, so daß eine große Zahl von elektrischen Anschlüssen auf kleiner Fläche möglich ist.

Nach der Erfindung ist eine einfache, zeitsparende Montage der Bedien- und Bauelemente des Hörgerätes ohne Lötvorgänge möglich. Ferner können im Servicefall Elemente einfach und zeitsparend ausgewechselt werden. Da die hohen Löttemperaturen entfallen, ist die Gefahr von Beschädigungen durch Temperatureinfluß eliminiert und die Anforderungen an die Temperaturbeständigkeit der Baukomponenten sind geringer. Die Montage der Bau- bzw. Bedienelemente ist automatisierbar und dadurch können die Montagezeiten verkürzt sowie Montagefehler ausgeschaltet werden. Schließlich läßt sich die Ausgestaltung der Bauteile und der Aufbau des Hörgerätes dadurch wesentlich vereinfachen, daß Lötbeinchen an den Bauteilen sowie Litzen und Drahtverbindungen im Hörgerät zumindest weitgehend entfallen.

Weitere Vorteile und Einzelheiten eines Ausführungsbeispieles der Erfindung ergeben sich aus der nachfolgenden Beschreibung zu Ausführungsbeispielen anhand der Zeichnung und in Verbindung mit den Patentansprüchen.

Es zeigt:
Figur 1 ein gemäß der Erfindung ausgebildetes Hörgerät 1, das im Ausführungsbeispiel als HdO-Gerät gestaltet ist, bei dem anstelle einer separaten Leiterplatte die auf einem Wandabschnitt 38 mit Leiterbahnen 16 versehene Innenwand des Gehäuseteils 3 ein Leiterplattenteil bildet,
Figur 2 eine Ansicht auf die Trägerplatte 17 einer Leiterplatte 15 eines Hörgerätes nach der Erfindung, an der ein Schalter 9, zum Beispiel ein M-T-O-Schalter, und ein Potentiometer 12 befestigt sind,
Figur 3 eine Stirnansicht zu Figur 2, aus der sich ergibt, daß der Schalter 9 und das Potentiometer 12 unter Zwischenlage eines anisotropen Körpers 19 gegen die die Leiterbahnen 16 tragende Leiterplattenseite gehalten werden,
Figur 4 die Draufsicht auf die die Leiterbahnen 16 tragende Seite der Leiterplatte 15 gemäß den Figuren 2 und 3,
Figur 5 in vergrößertem Maßstab und teilweise im Schnitt die erfindungsgemäße Anordnung eines Potentiometers 12 des Hörgerätes 1 an einer Leiterplatte 15,
Figur 6 in vergrößertem Maßstab und im Schnitt einen Schalteraufbau des Hörgerätes,
Figur 7 vergrößert dargestellt ein Detail des Schalters 9 nach Figur 6,
Figur 8 eine Kontaktplatte 28 des Schalters 9 nach den Figuren 6 und 7,
Figur 9 einen Querschnitt durch das Hörgerät nach Figur 1 bei geschlossenem Hörgerätgehäuse,
Figur 10 in einer vergrößerten Einzelheit die leitende Verbindung zwischen auf der Innenseite des Hörgerätgehäuseteils 3 angebrachten Leiterbahnen 16, einem folien- oder mattenförmigen anisotropen Körper 19 und Kontaktpunkten 18 entweder von elektrischen Bauteilen, die in dem anderen Hörgerätgehäuseteil 2 untergebracht sind und/oder von einer Verstärkerplatine 15′, die ebenfalls im Gehäuseteil 2 angeordnet ist und wiederum elektrische Bauelemente wie Schalter 9, Steller 10, Potentiometer 12, Filterchips oder sonstige Elektronikbausteine trägt, wobei im Ausführungsbeispiel an die Verstärkerplatine 15′ auch ein Batteriefederkontakt 8 angesetzt ist.

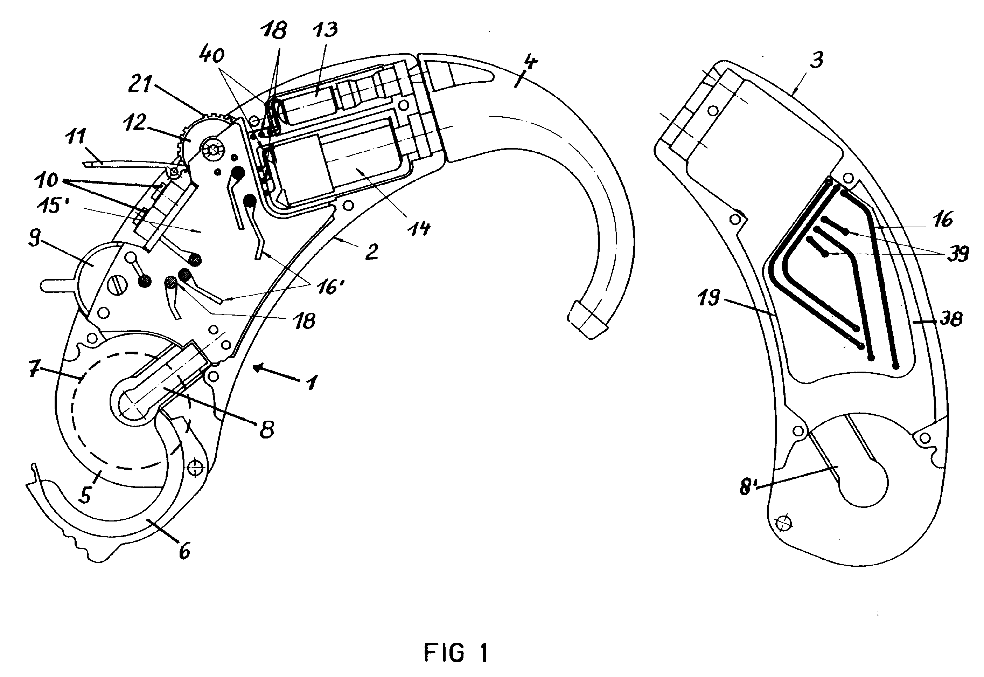

In der Figur 1 ist mit 1 ein hinter dem Ohr zu tragendes Hörgerät (HdO-Gerät) bezeichnet, dessen Gerätegehäuse beispielsweise aus einem schalenförmigen Gehäuseunterteil 2 und einem schalenförmigen Deckel 3 besteht. Zum Tragen am Ohr weist das Gehäuse an einem Ende einen Traghaken 4 auf. Zur Aufnahme einer Stromquelle, insbesondere einer Batterie 7, ist im Gehäuse ein Batteriefach 5 mit einer zugeordneten schwenkbaren Batterielade 6 vorgesehen. Zum Abgriff der Batteriepole sind ferner Batteriefederkontakte 8, 8′ vorhanden, die an die elektrische Schaltung des Hörgerätes angeschlossen sind. Zum Einschalten des Hörgerätes (Mikrofonbetrieb), zum Umschalten auf Telefonbetrieb und zum Abschalten des Hörgerätes (O-Stellung) ist im Ausführungsbeispiel ein MTO-Schalter 9 vorgesehen. Zur Veränderung bzw. Einstellung der Charakteristiken einer Verstärkerbaueinheit weist das Hörgerät 1 Steller 10 auf, die über eine Stellerklappe 11 des Gehäuses zugänglich sind. Aus dem Gehäuse ragt das Betätigungsglied 21 eines als Potentiometer 12 ausgebildeten Lautstärkereglers. Schließlich sind im Hörgerätgehäuse ein Mikrofon 13 und ein Hörer 14 angeordnet.

Bei der Ausführung nach Figur 1 - wobei der Deckel 3 vom Gehäuseunterteil 2 abgenommen dargestellt ist - sind die Bauelemente des Hörgerätes überwiegend im Unterteil 2 angeordnet, wobei eine Verstärkerplatine 15′ die elektrischen Bau- und Bedienteile 8, 9, 10, 12 trägt, Leiterbahnen 16′ aufweist, denen Kontakte bzw. Kontaktpunkte 18 zugeordnet sind, und wobei ferner die Schallwandler 13, 14 über ihre Anschlußlitzen 40 an die Elektrik der Verstärkerplatine 15′ angeschlossen sind.

Anstelle einer gesonderten Leiterplatte bildet ein Wandabschnitt 38 der Deckelinnenseite den Isolierträger für gegeneinander isoliert angebrachte Leiter 16. Diesen Leitern 16 sind Kontaktpunkte 39 zugeordnet. Mit 8′ ist ein Batteriefederkontakt eingezeichnet. Auf das mit den Bauteilen bestückte Gehäuseteil 2 wird unter Zwischenlage eines folien- oder mattenförmigen anisotropen, elektrisch leitenden Körpers 19 der Dekkel 3 aufgesetzt. Bei der Befestigung der beiden Gehäuseteile 2, 3 entsteht der erforderliche Kontaktdruck, der den gewünschten Stromkreis zwischen den elektrischen Bauteilen der Gehäuseteile herstellt bzw. schließt. Wie die Figur 1 zeigt, sind die elektrisch zu verbindenden Baugruppen mit Kontaktpunkten ausgeführt. Im Gehäusedeckel 3 befinden sich die benötigten Leiter - diese können im Gehäusedeckel durch Strukturierung von Leitern direkt im Kunststoff oder durch Einlegen flexibler Leiter erstellt werden - und durch Einlegen einer oder mehrerer Körper 19 vor dem Verschließen des Gehäuses werden zum Beispiel beim Verschrauben der Gehäuseteile die Leiter 16 mit den Kontaktpunkten 18 der Baugruppen 8-10, 12-14 bzw. der Verstärkerplatine 15′ verbunden.

Dieser erfindungsgemäße Hörgerätaufbau vereinigt die Vorteile: zeitsparende Endmontage der Hörgeräte ohne Lötverbindungen, zeitsparende Auswechselmöglichkeit der Hörgerätebaugruppen ohne Lösen und Erneuern von Lötverbindungen, Vermeidung schwierig zu handhabender Litzenverbindungen in der Endmontage, einfach und weitgehend automatisierbare Endmontage.

In den Figuren 9, 10 sind Einzelheiten des Gehäuseaufbaues des erfindungsgemäßen Hörgerätes dargestellt. Mit 41 ist eine Baugruppe der Verstärkerbaueinheit bezeichnet.

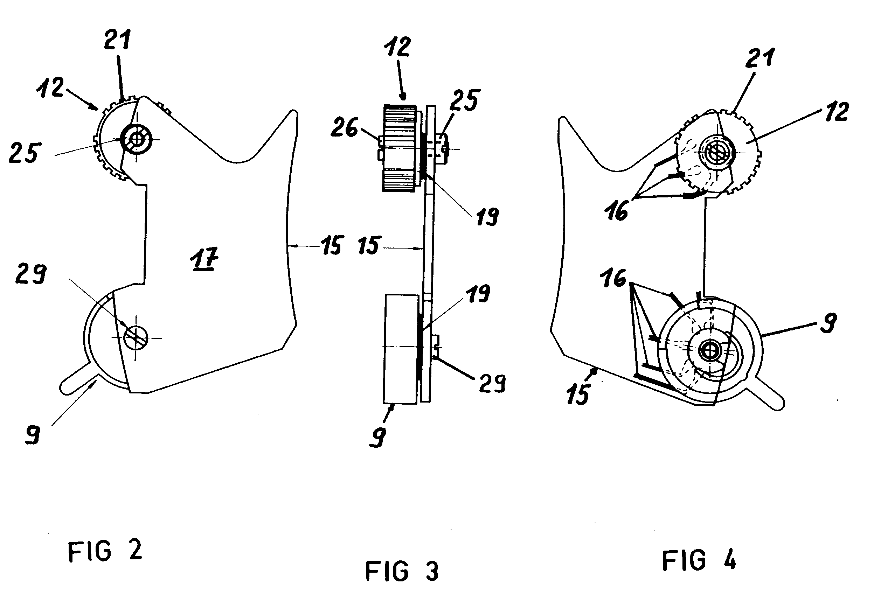

Bei der Ausführung nach den Figuren 2 bis 4 dient eine von einer Isolierstoffträgerplatte 17 gestützte Leiterplatte 15 als Halterung für einen Schalter 9 und ein Potentiometer 12. Dabei sind Schalter 9 und Potentiometer 12 unter Zwischenlage von anisotropen Körpern 19 gegen die die Leiterbahnen 16 aufweisende Leiterplattenseite abgestützt, derart, daß zwischen Leiterbahnen der Leiterplatte und elektrischen Kontakten des Schalters bzw. des Potentiometers stromleitende Verbindungen bestehen.

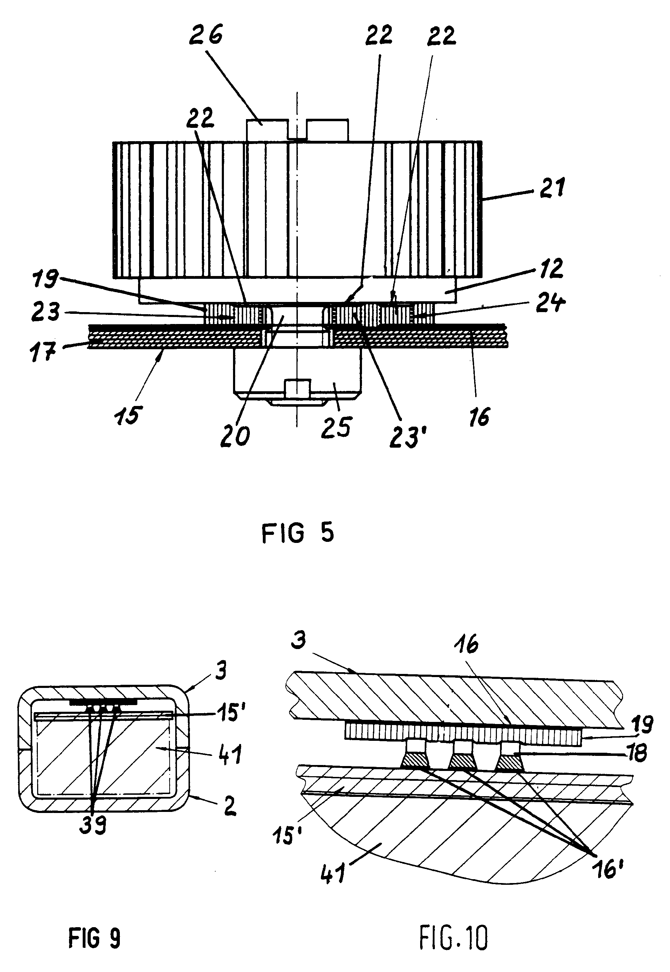

Unter Berücksichtigung der Ausführung nach Figur 5 ergibt sich für die Potentiometeranordnung, daß ein anisotroper elektrisch leitender Körper 19 mehrere Leiterbahnen 16 überdeckend auf einer Leiterplatte 15 aufliegt, daß durch den anisotropen Körper und die Leiterplatte ein Zapfen 20, eine Welle oder dergleichen geführt ist, die ein Betätigungsglied 21 des Potentiometers 12 trägt, daß an der auf dem anisotropen Körper aufliegenden Unterseite des Potentiometers Schleiferkontakte 22 oder dergleichen vorgesehen sind und daß der Zapfen zur Potentiometerhalterung gegen die Trägerplatte und für den Kontaktdruck der Schleiferkontakte gegen den anisotropen Körper sowie gegen die Leiterbahnen ausgebildet ist. Beim Ausführungsbeispiel besteht die Potentiometerhalterung aus einer Schraubmutter 25, die sich gegen die Trägerplatte 17 abstützt und in die der Zapfen 20 des Potentiometers 12 schraubbar ist. Mit 26 ist ein Anschlag oder eine Kontermutter oder dergleichen zur Halterung des Betätigungsgliedes 21 des Potentiometers bezeichnet. Mit 23, 23′ und 24 sind die bei der Potentiometerstellung nach Figur 5 sich ergebenden Kontaktbereiche zwischen den Kontaktpunkten 22 des Potentiometers 12 und den Leiterbahnen 16 - überbrückt durch den Körper 19 - bezeichnet.

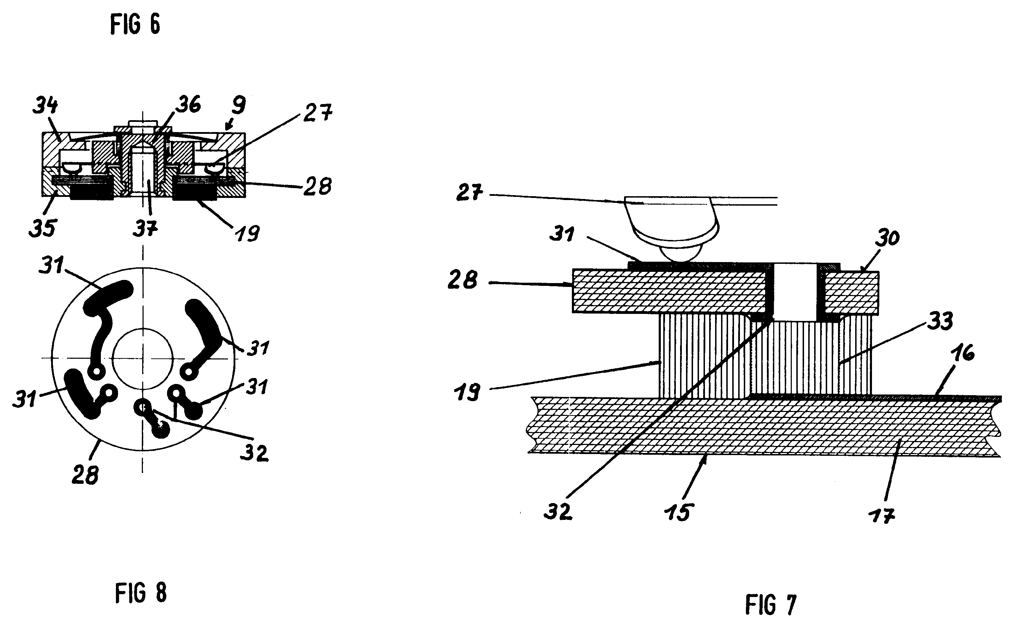

In den Figuren 6 bis 8 ist eine vorteilhafte Schalteranordnung des erfindungsgemäßen Hörgerätes gezeichnet. Dabei liegt ein anisotroper elektrisch leitender Körper 19 auf der Leiterbahnen 16 tragenden Seite der Leiterplatte 15 auf und es ist ein Schalter 9 vorgesehen, der wenigstens einen als Schleifer ausgebildeten beweglichen Schaltkontakt 27 und eine Kontaktplatte 28 aufweist, die sich auf den anisotropen Körper abstützt. Der Schalter ist mittels einem die Schalterhalterung und die Kontaktierung bewirkenden Befestigungsmittel, zum Beispiel einer Schraube 29 oder dergleichen, an der Trägerplatte 17 der Leiterplatte befestigbar.

Nach weiterer Ausgestaltung ist vorgesehen, daß der Schalter 9 ein zweiteiliges Gehäuse 34, 35 aufweist, daß in das Gehäuseunterteil 35 die Kontaktplatte 28 und der anisotrope Körper 19 eingesetzt sind, welcher bodenseitig aus dem Gehäuseunterteil mit einer Auflagefläche zu den Leiterbahnen der Leiterplatte vorsteht, daß im Gehäuseoberteil 34 eine Haltevorrichtung 36 für den oder die Schaltkontakte 27 sowie eine Aufnahme 37 für ein Befestigungselement, zum Beispiel eine Schraube 29, vorgesehen sind, und daß durch eine Bohrung der Leiterplatte das Befestigungselement 29 in die Aufnahme 27 der Schalter-Haltevorrichtung einesetzbar ist, derart, daß der Schalter mit Kontaktdruck zwischen den Kontakten 32 der Kontaktplatte 28, dem anisotropen Körper 19 und den Leiterbahnen 16 an der Trägerplatte 17 der Leiterplatte 15 befestigbar ist.

Gemäß einer Weiterbildung besteht die Kontaktplatte 28 aus elektrisch isolierendem Material, auf ihrer dem Schaltkontakt 27 bzw. Schaltkontakten zugeordneten Oberseite 30 trägt die Kontaktplatte 28 elektrisch leitende Schleiferabgriffe 31. Von den Schleiferabgriffen 31 sind Kontakte 32 durch die Kontaktplatte hindurchgeführt, wobei diese Kontakte 32 in leitender Verbindung gegen den anisotropen Körper 19 anliegen. Wie in Figur 7 angegeben ist, besteht in der gezeichneten Schalterstellung vom Schleiferkontakt 27 über den metallischen Schleiferabgriff 31 und über die Durchkontaktierung 32 eine leitende Verbindung zur Leiterbahn 16, bei einem Kontaktbereich 33 des Körpers 19.

## Patentansprüche

1. Hörgerät (1) mit wenigstens einem Mikrofon (13), einer Verstärkereinrichtung, einem Hörer (14) und einer Stromquelle (7) sowie mit weiteren als Steller (10), Schalter (9) und/oder Regelelemente ausgebildeten Bauelementen, die im Inneren des Hörgerätgehäuses (2, 3) an wenigstens einer Leiterplatte (15) kontaktiert sind, wobei zwischen den Leiterbahnen (16) der Leiterplatte (15) und Kontakten (18) der gegen die Leiterplatte befestigbaren Bauelemente (8-10, 12-14) ein anisotroper elektrisch leitender platten-, folien- oder mattenförmiger Körper (19), bestehend aus einem elektrisch isolierenden Matrixmaterial mit einer darin gleichmäßig verteilten Vielzahl von elektrisch leitenden und senkrecht zur Platten-, Folien- oder Mattenebene ausgerichteten Fasern, angeordnet ist, derart, daß der anisotrope, elektrisch leitende Körper (19) mehrere Leiterbahnen (16) überdeckend auf der Leiterplatte (15) aufliegt, **dadurch gekennzeichnet,** daß Steller (10), Potentiometer (12) und/oder Schalter (9) unter Zwischenlage des anisotropen Körpers (19) gegen die die Leiterbahnen (16) tragende Leiterplattenseite in bei Kontaktdruck elektrisch leitender Verbindung angeordnet sind, wobei durch den anisotropen Körper und die Leiterplatte ein Zapfen (20) oder eine Welle geführt ist, der bzw. die ein Betätigungsglied (21) des Potentiometers (12) bzw. eines Stellers (10) trägt, daß an der auf dem anisotropen Körper aufliegenden Unterseite des Potentiometers/Stellers Schleiferkontakte (22) vorgesehen sind und daß der Zapfen (20) bzw die Welle zur Potentiometer-/Stellerhalterung gegen die Trägerplatte und für den Kontaktdruck der Schleiferkontakte gegen den anisotropen Körper sowie gegen die Leiterbahnen ausgebildet ist.

2. Hörgerät nach Anspruch 1, wobei die Potentiometer-/Stellerhalterung aus einer Schraubmutter (25) besteht, die sich gegen die Trägerplatte (17) abstützt und in die der Zapfen (20) des Potentiometers (12) bzw. Stellers (10) schraubbar ist.

3. Hörgerät nach Anspruch 1, wobei der anisotrope elektrisch leitende Körper (19) auf der Leiterbahnen (16) tragenden Seite der Leiterplatte (15) aufliegt, wobei der Schalter (9) vorgesehen ist, der wenigstens einen als Schleifer ausgebildeten beweglichen Schaltkontakt (27) und eine Kontaktplatte (28) aufweist, die sich auf den anisotropen Körper abstützt, und wobei der Schalter mittels einem die Schalterhalterung und die Kontaktierung bewirkenden Befestigungsmittel (29) an der Trägerplatte (17) der Leiterplatte befestigbar ist.

4. Hörgerät nach Anspruch 1 und 3, wobei der Schalter (9) ein zweiteiliges Gehäuse (34, 35) aufweist, wobei in das Gehäuseunterteil (35) die Kontaktplatte (28) und der anisotrope Körper (19) eingesetzt sind, welcher bodenseitig auf dem Gehäuseunterteil mit einer Auflagefläche zu den Leiterbahnen der Leiterplatte vorsteht, wobei im Gehäuseoberteil (34) eine Haltevorrichtung (36) für den oder die Schaltkontakte (27) sowie eine Aufnahme (37) für ein Befestigungselement, z.B. eine Schraube (29), vorgesehen sind, und wobei durch eine Bohrung der Leiterplatte das Befestigungselement (29) in die Aufnahme (37) der Schalter-Haltevorrichtung einsetzbar ist, derart, daß der Schalter mit Kontaktdruck zwischen den Kontakten (32) der Kontaktplatte (28), dem anisotropen Körper (19) und den Leiterbahnen (16) an der Trägerplatte (17) der Leiterplatte (15) befestigbar ist.

5. Hörgerät nach Anspruch 3 oder 4, wobei die Kontaktplatte (28) aus elektrisch isolierendem Material besteht, auf ihrer dem Schaltkontakt (27) bzw. Schaltkontakten zugeordneten Oberseite (30) elektrisch leitende Schleiferabgriffe (31) trägt und wobei durch die Kontaktplatte hindurchgeführte Kontakte (32) der Schleiferabgriffe gegen den anisotropen Körper (19) kontaktierend anliegen.

6. Hörgerät nach Anspruch 1, wobei ein Wandabschnitt (38) der Gehäuseinnenwand des Hörgerätgehäuses (3) mit gegeneinander isolierend angeordneten Leiterbahnen (16) versehen ist, wobei die Leiterbahnen (16) Kontaktstellen (39) aufweisen und wobei im Hörgerätgehäuse (2) angeordnete Bauelemente (8-10, 12-14) mit ihren elektrischen Kontakten (18) unter Zwischenlage des anisotropen elektrisch leitenden Körpers (19) kontaktierend gegen die Leiterbahnen (16) bzw. deren Kontaktstellen (39) abgestützt sind.

7. Hörgerät nach Anspruch 6, wobei das Hörgerätgehäuse aus einer Bodenschale (2) und einem Deckel (3) besteht, wobei in dem einen Gehäuseteil (2) die Bauelemente (8-10; 12-14) und auf der Innenwandung des anderen Gehäuseteils (3) die Leiterbahnen (16) gegeneinander isoliert angeordnet sind, wobei in das Gehäuse der anisotrope elektrisch leitende Körper (19) einlegbar ist, derart, daß beim Zusammenfügen der Bodenschale (2) mit dem Deckel (3) eine kontaktierende Verbindung zwischen den Leiterbahnen (16) über den anisotropen Körper (19) zu den elektrischen Kontakten (18) der Bauelemente herstellbar ist.

## Claims

1. Hearing aid (1) having at least one microphone (13), an amplifier device, a receiver (14) and a current source (7) and having further components formed as setter (10), switch (9) and/or control elements, the components being contacted in the interior of the hearing-aid housing (2, 3) to at least one printed circuit board (15), whereby an anisotropic electroconductive plate-shaped, film-shaped or mat-shaped body (19), consisting of an electrically insulating matrix material with a plurality of electroconductive fibres aligned perpendicularly to the plate plane, film plane or mat plane and distributed evenly in the matrix material, is arranged between the printed conductors (16) of the printed circuit board (15) and contacts (18) of the components (8-10, 12-14) fastenable to the printed circuit board in such a way that the anisotropic, electroconductive body (19) rests on the printed circuit board (15), covering several printed conductors in the process, characterized in that the setter (10), potentiometer (12) and/or switch (9) with interposition of the anisotropic body (19) are arranged against the side of the printed circuit board supporting the printed conductors (16) in connection which is electroconductive upon contact pressure, whereby a lug (20) or a shaft is guided through the anisotropic body and the printed circuit board, the lug or shaft supporting an actuation element (21) of the potentiometer (12) or a setter (10), in that slider contacts (22) are provided on the underside of the potentiometer/setter resting on the anisotropic body and in that the lug (20) or the shaft is constructed against the support plate for the potentiometer/setter support and against the anisotropic body and against the printed conductors for the contact pressure of the slider contacts.

2. Hearing aid according to claim 1, whereby the potentiometer/setter support consists of a screw nut (25) which is supported against the support plate (17) and into which the lug (20) of the potentiometer (12) or setter (10) can be screwed.

3. Hearing aid according to claim 1, whereby the anisotropic electroconductive body (19) rests on the side of the printed circuit board (15) supporting printed conductors (16), whereby the switch (9) is provided which has at least one moveable switching contact (27) constructed as slider and a contact plate (28) which is supported on the anisotropic body, and whereby the switch can be fastened to the support plate (17) of the printed circuit board by means of fastening means (29) effecting the switch support and the contacting.

4. Hearing aid according to claims 1 and 3, whereby the switch (9) has a two-part housing (34, 35), whereby the contact plate (28) and the anisotropic body (19) are inserted into the lower part of the housing (35), with the body projecting on the base side on the lower part of the housing with a contact surface to the printed conductors of the printed circuit board, whereby in the upper part of the housing (34) a supporting device (36) is provided for the switching contact(s) (27) and a mounting (37) is provided for a fastening element, for example a screw (29), and whereby the fastening element (29) can be inserted through a bore of the printed circuit board into the mounting (37) of the switch supporting device in such a way that the switch can be fastened to the support plate (17) of the printed circuit board (15) with contact pressure between the contacts (32) of the contact plate (28), the anisotropic body (19) and the printed conductors (16).

5. Hearing aid according to claim 3 or 4, whereby the contact plate (28) consists of electrically insulating material, supports electroconductive slider taps (31) on its upper side (30) associated with the switching contact (27) or switching contacts and whereby contacts (32) of the slider taps guided through the contact plate abut the anisotropic body (19) in a contacting manner.

6. Hearing aid according to claim 1, whereby a wall section (38) of the inner housing wall of the hearing-aid housing (3) is provided with printed conductors (16) arranged so as to be insulated from one another, whereby the printed conductors (16) have contact points (39) and whereby components (8-10, 12-14) arranged in the hearing-aid housing (2) with their electrical contacts (18) with interposition of the anisotropic electroconductive body (19) are supported in a contacting manner against the printed conductors (16) or their contact points (39).

7. Hearing aid according to claim 6, whereby the hearing-aid housing consists of a pan (2) and a cover (3), whereby in the one housing part (2) the components (8-10; 12-14) and on the inner wall of the other housing part (3) the printed conductors (16) are arranged so as to be insulated from one another, whereby the anisotropic electroconductive body (19) can be placed into the housing in such a way that when the pan (2) is joined to the cover (3) a contacting connection between the printed conductors (16) by way of the anisotropic body (19) to the electrical contacts (18) of the components can be produced.

## Revendications

1. Appareil de correction auditive (1) comprenant au moins un microphone (13), un dispositif amplificateur, un écouteur (2) et une source de courant (7) ainsi que d'autres composants agencés sous la forme d'un régulateur (10), d'un commutateur (9) et/ou d'éléments de réglage et qui sont, à l'intérieur du boîtier (2,3) de l'appareil de correction auditive, en contact avec au moins une plaquette à circuits imprimés (15), et dans lequel entre les voies conductrices (16) de la plaquette à circuits imprimés (15) et les contacts (18) des composants (8 à 10, 12 à 14) qui peuvent être fixés contre la plaquette à circuits imprimés est disposé un corps anisotrope électriquement conducteur (19), en forme de plaque, de feuille ou de nappe, en un matériau électriquement isolant formant matrice et comportant; réparties uniformément en son sein, une pluralité de fibres électriquement conductrices, dirigées perpendiculairement au plan de la plaque, de la feuille ou de la nappe, de telle sorte que le corps (19) anisotrope et électriquement conducteur recouvre plusieurs voies conductrices (16) sur la plaquette à circuits imprimés (15), caractérisé par le fait que le régulateur (10), un potentiomètre (12) et/ou le commutateur (9) sont disposés, avec interposition du corps anisotrope (10), contre la face de la plaquette à circuits imprimés, qui porte les voies conductrices (16), en y étant reliés selon une liaison électrique sous l'application d'une pression de contact, un téton (20) ou un arbre traversant le corps anisotrope et la plaquette à circuits imprimés, ce téton ou cet arbre portant un organe d'actionnement (21) du potentiomètre (12) ou d'un régulateur (10), que des contacts formant curseurs (22) sont prévus sur la face inférieure, qui s'applique sur le corps anisotrope, du potentiomètre/régulateur, et que le téton (20) ou l'arbre est agencé de manière à retenir le potentiomètre/le régulateur contre la plaque de support pour appliquer la pression des contacts formant curseurs contre le corps anisotrope et contre les voies conductrices.

2. Appareil de correction auditive suivant la revendication 1, dans lequel la fixation du potentiomètre/ du régulateur est constituée d'un écrou (25), qui prend appui sur la plaque de support (17) et dans lequel peut être vissé le téton (20) du potentiomètre (12) ou du régulateur (10).

3. Appareil de correction auditive suivant la revendication 1, dans lequel le corps anisotrope électriquement conducteur (19) s'applique sur la face, qui porte les voies conductrices (16), de la plaquette à circuits imprimés (15), le commutateur (9) comportant au moins un contact mobile de commutation (27), réalisé sous la forme d'un curseur, et une plaque porte-contacts (28), qui prend appui sur le corps anisotrope, et pouvant être fixée, à l'aide d'un moyen de fixation (29) retenant le commutateur et établissant le contact, sur la plaque de support (17) de la plaquette à circuits imprimés.

4. Appareil de correction auditive suivant la revendication 1 ou 3, dans lequel le commutateur (9) comporte un boîtier (34,35) en deux parties, dans la partie inférieure (35) duquel sont insérées la plaque porte-contacts (28) et le corps anisotrope (19), qui fait saillie, du côté du fond, sur la partie inférieure du boîtier par une surface d'appui en direction des voies conductrices de la plaquette à circuits imprimés, tandis qu'il est prévu dans la partie supérieure (34) du boîtier un dispositif de retenue (36) pour le ou les contacts de commutation (27) ainsi qu'un logement (37) pour un élément de fixation, par exemple une vis (29), l'élément de fixation ((22) pouvant être inséré, par un perçage ménagé dans la plaquette à circuits imprimés, dans le logement (37) du dispositif de retenue du commutateur de telle sorte que le commutateur peut être fixé, avec une pression de contact entre les contacts (32) de la plaque porte-contacts (28), le corps anisotrope (19) et les voies conductrices (16) sur la plaque de support (17) de la plaquette à circuits imprimés (15).

5. Appareil de correction auditive suivant la revendication 3 ou 4, dans lequel la plaque porte-contacts (28) est en un matériau électriquement isolant, porte, sur sa face supérieure (30) associée au contact de commutation (27) ou aux contacts de commutation, des prises électriquement conductrices formant curseurs (31), des contacts (32), qui traversent la plaque porte-contact, des prises formant curseurs s'appliquant, en établissant un contact, sur le corps anisotrope (19).

6. Appareil de correction auditive suivant la revendication 1, dans lequel une partie (38) de la paroi intérieure du boîtier (3) de l'appareil de correction auditive est pourvue de voies conductrices (16), qui sont isolées les unes des autres, dans lequel les voies conductrices (16) comportent des plages de contact (39), et dans lequel des composants (8 à 10, 12 à 14), disposés dans le boîtier (2) de l'appareil de correction auditive sont en appui par leurs contacts électriques (18), avec interposition du corps anisotrope électriquement conducteur (19), sur les voies conductrices (16) ou leurs points de contact (39).

7. Appareil de correction auditive suivant la revendication 6, dans lequel le boîtier de l'appareil de correction auditive est constitué d'une coque de fond (2) et d'un couvercle (3), les composants (8 à 10; 12 à 14) sont disposés dans une partie (2) du boîtier et les voies conductrices (16) sont disposées en étant isolées les unes des autres sur la paroi intérieure de l'autre partie (3) du boîtier, et le corps anisotrope électriquement conducteur (19) peut être inséré dans le boîtier de telle sorte que, lors de l'assemblage de la coque de fond (2) au couvercle (3), une liaison de contact peut être établie entre les voies conductrices (16) et les contacts électriques (18) par l'intermédiaire du corps anisotrope (19).
